# EUROPÄISCHE PATENTANMELDUNG

(11) **EP 1 225 668 A2**
(43) Veröffentlichungstag der Anmeldung: **24.07.2002**
(21) Anmeldenummer: 02001333.0
(22) Anmeldetag: 18.01.2002
(51) Int. Cl.: H01S 5/022, H01S 5/042, H01S 5/40

(54) **Lasermodul**

(30) Priorität: 18.01.2001 DE 10102264
(71) Anmelder: Amtron GmbH, 52146 Würselen (DE)
(72) Erfinder: Aehling, Hubert, Dipl.-Ing., 52072 Aachen (DE)
(74) Vertreter: Grimm, Ekkehard, Dipl.-Phys.

(57) **Zusammenfassung**

Die Erfindung beschreibt ein Lasermodul mit mindestens einer Laserdiode mit kollimiertem Strahlaustritt, einer Einheit zur Strahlführung und Formung der von der Laserdiode abgegebenen Strahlung, einer Leistungselektronik zur direkten Ansteuerung der Laserdiode, mit einer Steuereinheit mit Interface zur Ansteuerung und Regelung der Laserdiode, sowie einem Gehäuse mit Wärmesenke für die Laserdiode, wobei an der Laserdiode ein Schaltregler integriert ist, der aus einer Zwischenkreisspannung von etwa 280-400V Gleichstrom die für die Diode erforderlichen 40-100A erzeugt und wobei die Zuführung der Energie über die Zwischenkreisspannung den Zuleitungsstrom auf ca. 0,5A absenkt.

## Beschreibung

Die Erfindung betrifft ein Lasermodul mit mindestens einer Laserdiode.

Hochleistungsdiodenlaser (Laserbarren wie sie in der Materialbearbeitung verwendet werden) benötigen zum Betrieb einen Strom von ca. 50 bis 100 A. Die Flussspannung an einer Diode beträgt ca. 2V. Die Steigerung der Diodenleistung kann nur durch eine weitere Erhöhung des Diodenstromes erreicht werden. Der hohe Strom erfordert große Leistungsquerschnitte von 10-20qmm. Bisher sind Stromversorgung und Diodenlaser getrennt aufgebaut und über entsprechend dicke Zuleitungen miteinander verbunden. Anwendungen, wie z.B. das Simultanschweißen, in denen mehrere einzeln ansteuerbare Diodenlaser parallel betrieben werden lassen sich aufgrund der dann erforderlichen vielen parallelen dicken Kupferleitungen nur sehr schwer realisieren und sind in bewegten Systemen kaum einsetzbar. Die extreme Störempfindlichkeit der Laserdioden auf transiente Strom- und Spannungsspitzen erfordern zusätzliche Schutzmaßnahmen.

Der vorliegenden Erfindung liegt die Aufgabe zugrunde, ein Lasermodul anzugeben, das sich durch seinen besonders kompakten Aufbau auszeichnet und unter anderem zur direkten Materialbearbeitung einsetzbar ist.

Diese Aufgabe wird mit einem Lasermodul gelöst mit mindestens einer Laserdiode mit kollimiertem Strahlaustritt, einer Einheit zur Strahlführung und Formung der von der Laserdiode abgegebenen Strahlung, einer Leistungselektronik zur direkten Ansteuerung der Laserdiode, mit einer Steuereinheit mit Interface zur Ansteuerung und Regelung der Laserdiode, sowie einem Gehäuse mit Wärmesenke für die Laserdiode, wobei an der Laserdiode ein Schaltregler integriert ist, der aus einer Zwischenkreisspannung von etwa 280-400V Gleichstrom die für die Diode erforderlichen 40-100A erzeugt und wobei die Zuführung der Energie über die Zwischenkreisspannung den Zuleitungsstrom auf ca. 0,5A absenkt.

Dieses Modul zeichnet sich durch seinen kompakten Aufbau aus.

In einer bevorzugten Ausführungsform wird zur Stromversorgung mindestens ein hochfrequenter Schaltregler mit Stromsteuerung eingesetzt. Hierdurch wird erreicht, dass kompakt und verlustarm eine Umsetzung der Zwischenkreisspannung auf den Diodenstrom stattfindet.

Der Schaltregler (Switchmode Power Supply) kann zur Umsetzung der Zwischenkreisspannung auf den Diodenstrom dienen, wodurch eine verlustarme Umsetzung der zugeführten Energie auf den Hochstromkreis stattfindet.

Der Schaltregler kann weiterhin mit einer Stromregelung ausgestattet werden, für die der aktuelle Strom gemessen und mit dem Sollwert verglichen wird. Die Stellgröße kann hierbei so geregelt werden, dass der aktuelle Strom der Stromvorgabe (dem Sollstrom) folgt.

Die Stromvorgabe kann über eine Mikrosteuereinheit in analoger oder digitaler Form vorgegeben werden. Gerade eine Mikrosteuereinheit zeichnet sich hierbei dadurch aus, dass das Lasermodul direkt an ein Feldbus-System angeschlossen werden kann. In einer bevorzugten Weiterbildung des Lasermoduls ist die Leistungselektronik zusammen mit der mindestens einen Laserdiode auf eine Wärmesenke montiert und führt so zu einem extrem kompakten und einfachen Aufbau. Weiterhin führt die direkte Sromwandlung mit Regelung an der Diode aufgrund der geringen Zuleitungslänge und einer vorgegebenen abgeschirmten Geometrie zu einem hoch dynamischen System mit extrem hoher Störsicherheit.

Die Messeinrichtung kann mit einem Strahlungspyrometer und einer Leistungsmesseinrichtung zur Prozesskontrolle und Regelung der Laserdiode ausgestattet werden. Mit diesen Komponenten wird zusammen mit der Mikrosteuereinheit ein geregelter Prozessbetrieb gefahren.

Als Steuereinheit kann eine Mikrosteuereinheit eingesetzt werden, die dann zu bevorzugen ist, wenn mehrere Module parallel aus einem Bus betrieben werden sollen, und/oder eine Prozessregelung stattfinden soll.

Falls die Laserleistung digital über ein Feldbus-System vorgegeben wird, ist das Lasermodul busfähig. Aufgrund der geringen Stromlast können mehrere Module parallel über eine Zuleitung betrieben werden.

Damit jedes Modul individuell gesteuert werden kann, erfolgt die Sollwertvorgabe digital über ein Feldbus-System.

In einer weiteren Ausgestaltung des Moduls werden zwei Messeinrichtungen vorgesehen, wobei die eine zur Laserleistungsmessung dient und die andere ein Pyrometer zur Messung der Strahlungsemission aus der Bearbeitungszone umfasst, wobei die Signale aus der Leistungsmessung und der Temperaturerfassung in der Bearbeitungszone über das Pyrometer zur Prozessregelung und Prozesskontrolle herangezogen werden. Eine solche Anordnung sollte dann herangezogen werden, wenn bei der Bearbeitung gegebene Temperaturbedingungen eingehalten werden müssen.

Weiterhin kann bei diesem Aufbau für die Temperaturregelung als Sollwert eine Temperatur vorgegeben werden, wobei in der Mikrosteuereinheit die aktuell gemessene Temperatur mit der Vorgabe verglichen wird und die Laserleistung so geregelt wird, dass die aktuelle, gemessene Temperatur der Vorgabe folgt.

Das Lasermodul zeichnet sich auch dadurch aus, dass es über eine digitale Schnittstelle mit folgenden Betriebsarten betreibbar ist:
(a) Stromvorgabe bei einfacher Stromregelung
(b) Temperaturvorgabe bei Stromregelung mit überlagerter Temperaturregelung
(c) Leistungsvorgabe bei Stromregelung mit überlagerter Leistungsregelung

Durch eine Änderung der Programmierung in den Modulen kann ohne Hardwareänderung das Regel- und Betriebsverhalten der Module verändert werden. Dies führt zu universell einsetzbaren Modulen, die für verschiedene Anwendung leicht modifiziert werden können.

Das Lasermodul ist eine kompakte Lasereinheit zur direkten Materialbearbeitung. Mögliche Einsatzgebiete sind: Kunststoffbearbeitung, Metallbearbeitung und das Laserlöten.

Die Messung der Diodenparameter Strom, Spannung und Leistung und der Prozessparameter wie Laserleistung und Temperatur werden zur Überwachung des Moduls und zur Prozesskontrolle genutzt.

Dadurch, dass in einem Modul die Laserdiode mit allen optischen Komponenten und die Meßeinrichtung integriert sind, kann jedes Modul für sich vollständig kalibriert werden. Damit ist im Fehlerfall ein einfacher Austausch in bestehenden Anlagen und Applikationen möglich.

Weiterhin ist anzumerken, dass die Energieversorgung aus der Netzversorgung eine Zwischenkreisspannung von z.B. ca. 400V DC zur Versorgung der Module zur Verfügung stellt. Ebenfalls werden hier die Kleinspannungen zur Versorgung der Modulelektronik bereitgestellt. Es kann auch die Anpassung an die landes- oder einsatzspezifischen Stromnetze erfolgen. Auch kann die Energieversorgung für die Versorgung von mehreren Modulen ausgelegt werden.

Das Lasermodul läßt sich insbesondere in zwei Ausführungsvarianten betreiben, zum einen in der Form der Trennung zwischen Meßeinheit und Lasersteuerung, zum anderen in einem Betrieb ohne Pyrometer und/oder Leistungsmessung.

Weitere Einzelheiten und Merkmale der Erfindung ergeben sich aus der nachfolgenden Beschreibung von Ausführungsbeispielen anhand der Zeichnungen.

In der Zeichnung zeigt
- Figur 1: das Konzept eines Lasermoduls gemäß der Erfindung sowie einen Aufbau mit mehreren über ein Bus-System verbundenen Lasermodulen,
- Figur 2: eine detailliertere Darstellung eines einzelnen Lasermoduls,
- Figur 3: verschiedene Kombinationen von Modulkomponenten und
- Figur 4: eine mögliche Ausführung für die Aneinanderreihung von Modulen zur Erzeugung einer Bearbeitungsnaht.

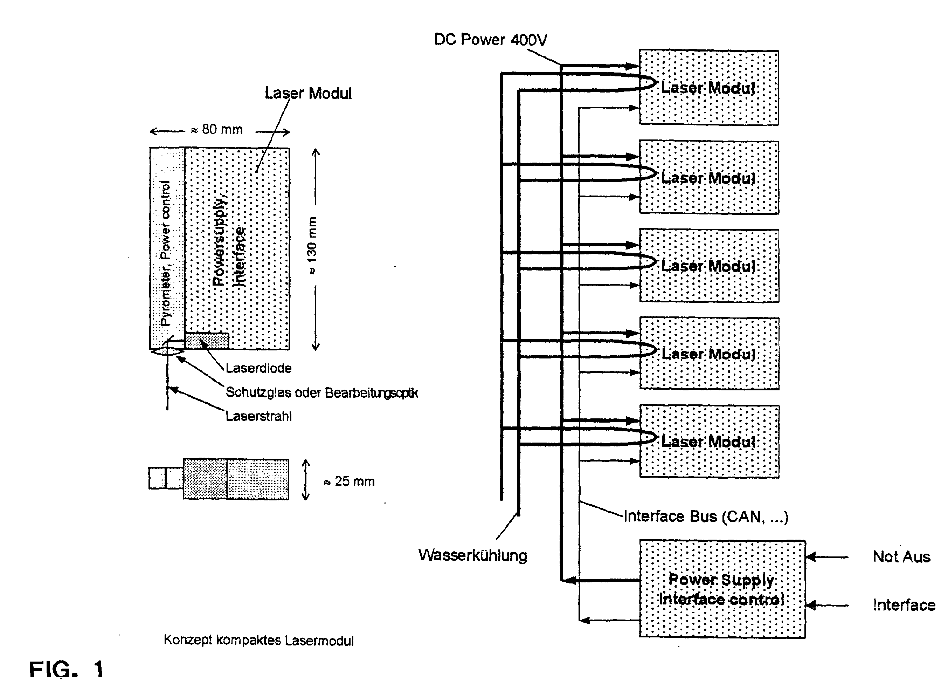

In Figur 1 ist das Konzept eines Lasermoduls gemäß der Erfindung in der linken Darstellung sowie ein Aufbau mit mehreren über ein Bus-System verbundenen Lasermodulen in der rechten Darstellung gezeigt. Ein Lasermodul, wie es in der linken Darstellung der Figur 1 gezeigt ist, besitzt ein Gehäuse mit äußeren Abmessungen von 80 mm x 130 mm x 25 mm, wobei sich diese Dimensionen unmittelbar aus der Figur ergeben. An einer Stirnseite dieses Gehäuses ist eine Laserdiode angeordnet, die ihre Strahlung parallel zur Stirnseite des Gehäuses abgibt. Die Strahlung wird über einen Umlenkspiegel um 90° umgelenkt und tritt aus der Gehäuseeinheit über ein Schutzglas oder eine Bearbeitungsoptik aus. Seitlich ist ein Pyrometer angeordnet sowie eine Energiesteuereinheit. Somit ergibt sich ein sehr kompakter Aufbau dieses Lasermoduls.

Wie in der rechten Darstellung angedeutet ist, können über ein Bus-System, bezeichnet mit Interface Bus (CAN, ....) mehrere Lasermodule zentral mit Energie versorgt werden. Auch ist eine zentrale Wasserkühlung vorgesehen, um die Wärme von den einzelnen Lasermodulen abzuführen. Die Energieversorgung bzw. (Power Supply) und Schnittstellensteuereinheit (Interface Controll) kann über einen Not-Aus-Schalter sowie eine weitere Schnittstelle angesteuert werden.

Wie aus Figur 1 ersichtlich ist, enthält das dargestellte Modul eine Vorrichtung zur Laserleistungsmessung sowie ein Pyrometer zur Messung der Strahlungsemission aus der Bearbeitungszone. Mit der Leistungsmessung kann die Degradation der Laserdiode ausgeglichen werden. Mit dem Pyrometer wird die Temperatur in der Bearbeitungszone gemessen. Beide Signale können für eine Prozessregelung und eine Prozesskontrolle herangezogen werden.

Bei einer Temperaturregelung wird als Sollwert eine Temperatur vorgegeben. In der Steuereinheit wird dann die aktuell gemessene Temperatur mit der Vorgabe verglichen. Die Laserleistung wird so geregelt, dass die aktuelle, gemessene Temperatur der Vorgabe folgt.

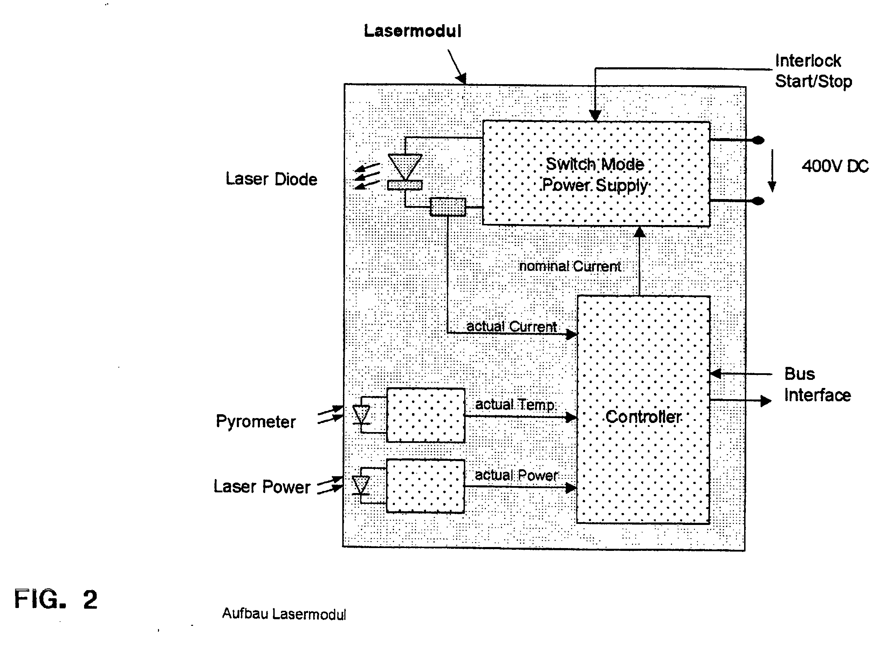

Figur 2 zeigt den inneren Aufbau eines Lasermoduls. Es besitzt im oberen Teil einen Schaltregler (Switch Mode Power Supply) zur Umsetzung der Zwischenkreisspannung auf den Diodenstrom. Um die Laserleistung zu steuern, ist der Schaltregler mit einer Stromregelung ausgestattet. Dazu wird der aktuelle Strom gemessen und mit dem Sollwert verglichen. Die Stellgröße wird so geregelt, das der aktuelle Strom der Stromvorgabe (dem Sollstrom) folgt.

Die Sollstromvorgabe kann analog oder Digital über eine Mikrosteuereinheit erfolgen.

Die Leistungselektronik kann zusammen mit der Laserdiode auf einer Wärmesenke montiert werden, wie bereits anhand der Figur 1 erläutert ist, und führt so zu einem extrem kompakten und einfachen Aufbau. Die direkte Stromumwandlung mit Regelung an der Diode führt aufgrund der geringen Zuleitungslänge und einer vorgegebenen, abgeschnittenen Geometrie zu einem hoch dynamischen System mit extrem hoher Störsicherheit.

Wie anhand der Figur 2 gezeigt ist, kann das Lasermodul eine Mikrosteuereinheit enthalten, so dass die Laserleistung digital über ein Feldbus-System vorgegeben werden kann. Somit ist das Lasermodul busfähig, wie dies auch in Figur 1 gezeigt und vorstehend angegeben ist. Aufgrund der geringen Stromlast können dann mehrere Module parallell über eine gemeinsame Zuleitung betrieben werden. Auch könnte die Sollwertvorgabe digital, z.B. über ein CAN-Bus-System, erfolgen, so dass auch dann jedes Modul individuell gesteuert werden kann.

Der schematische Schaltungsaufbau ist unmittelbar der Figur 2 zu entnehmen.

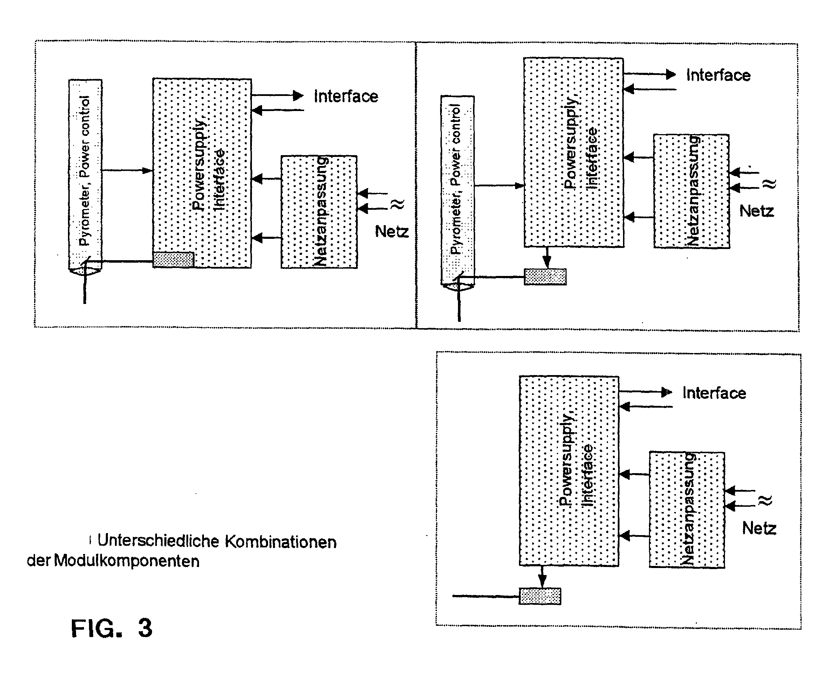

Die Figur 3 zeigt unterschiedliche Kombinationen von Modulkomponenten. So umfaßt jedes der oberen beiden, unmittelbar miteinander verbundenen Module, vergleichbar mit dem vorstehend anhand der Figuren 1 und 2 beschriebenen Aufbau, eine Laserdiode mit Energieversorgung/Schnittstelle (Power Supply/Intedace), ein Pyrometer mit einer Energiesteuereinheit sowie eine Netzspannungsversorgung. Mehrere solche Module, in Figur 3 zwei an der Zahl, können zu einer Einheit kombiniert werden.

Die weitere Modulkomponente, die im unteren Teil der Figur 3 gezeigt ist, entspricht den Modulen, die darüber zu sehen sind, allerdings ohne Pyrometer und Energiesteuereinheit.

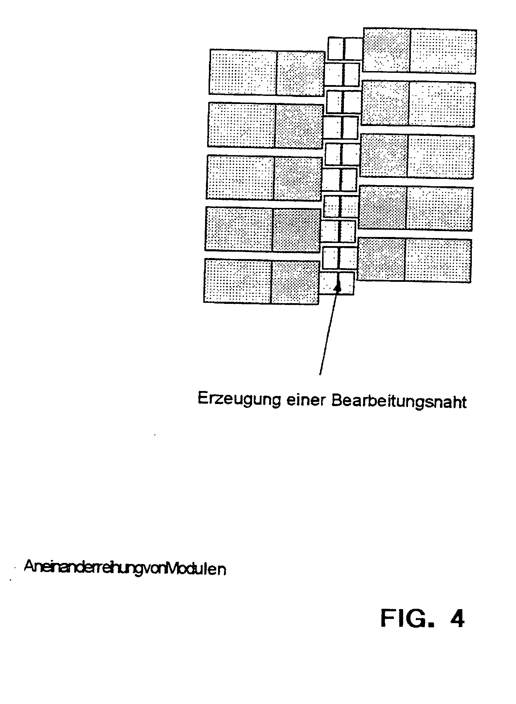

In Figur 4 ist nun ein Anwendungsbeispiel von 10 Lasermodulen, wie sie vorstehend beschrieben sind, dargestellt, um beispielsweise eine Bearbeitungsnaht zu erzeugen. Die jeweiligen Module sind wechselweise gegenüberliegend angeordnet, so dass sich ein kompakter Aufbau ergibt. Die 10 Module können über ein Bus-System gemeinsam angesteuert und betrieben werden, wie es in Figur 1 gezeigt ist.

## Patentansprüche

1. Lasermodul mit mindestens einer Laserdiode mit kollimiertem Strahlaustritt, einer Einheit zur Strahlführung und Formung der von der Laserdiode abgegebenen Strahlung, einer Leistungselektronik zur direkten Ansteuerung der Laserdiode, mit einer Steuereinheit mit Interface zur Ansteuerung und Regelung der Laserdiode, sowie einem Gehäuse mit Wärmesenke für die Laserdiode, wobei an der Laserdiode ein Schaltregler integriert ist, der aus einer Zwischenkreisspannung von etwa 280-400V Gleichstrom die für die Diode erforderlichen 40-100A erzeugt und wobei die Zuführung der Energie über die Zwischenkreisspannung den Zuleitungsstrom auf ca. 0,5A absenkt.

2. Lasermodul nach Anspruch 1, **dadurch gekennzeichnet, dass** zur Stromversorgung mindestens ein hochfrequenter Schaltregler mit Stromsteuerung eingesetzt ist.

3. Lasermodul nach Anspruch 1, **dadurch gekennzeichnet, dass** der Schaltregler (Switchmode Power Supply) zur Umsetzung der Zwischenkreisspannung auf den Diodenstrom dient.

4. Lasermodul nach Anspruch 1, **dadurch gekennzeichnet, dass** der Schaltregler mit einer Stromregelung ausgestattet ist, für die der aktuelle Strom gemessen und mit dem Sollwert verglichen wird.

5. Lasermodul nach Anspruch 4, **dadurch gekennzeichnet, dass** die Stellgröße so geregelt ist, dass der aktuelle Strom der Stromvorgabe (dem Sollstrom) folgt.

6. Lasermodul nach Anspruch 4 oder 5, **dadurch gekennzeichnet, dass** die Stromvorgabe über eine Mikrosteuereinheit in analoger oder digitaler Form vorgegeben ist.

7. Lasermodul nach Anspruch 1, **dadurch gekennzeichnet, dass** die Leistungselektronik zusammen mit der mindestens einen Laserdiode auf eine Wärmesenke montiert ist.

8. Lasermodul nach Anspruch 1, **dadurch gekennzeichnet, dass** eine Messeinrichtung mit einem Strahlungspyrometer und einer Leistungsmesseinrichtung zur Prozesskontrolle und Regelung der Laserdiode vorgesehen ist.

9. Lasermodul nach Anspruch 1, **dadurch gekennzeichnet, dass** als Steuereinheit eine Mikrosteuereinheit eingesetzt ist.

10. Lasermodul nach Anspruch 1, **dadurch gekennzeichnet, dass** die Laserleistung digital über ein Feldbussystem vorgegeben wird.

11. Lasermodul nach Anspruch 10, **dadurch gekennzeichnet, dass** mehrere Module parallel über eine Zulieitung betrieben werden.

12. Lasermodul nach Anspruch 11, **dadurch gekennzeichnet, dass** die Sollwertvorgabe digital über ein Feldbus-System erfolgt.

13. Lasermodul nach Anspruch 1, **dadurch gekennzeichnet, dass** zwei Messeinrichtungen vorgesehen sind, wobei die eine zur Laserleistungsmessung dient und die andere ein Pyrometer umfasst zur Messung der Strahlungsemission aus der Bearbeitungszone, wobei die Signale aus der Leistungsmessung und der Temperaturerfassung in der Bearbeitungszone über das Pyrometer zur Prozessregelung und Prozesskontrolle herangezogen werden.

14. Lasermodul nach Anspruch 13, **dadurch gekennzeichnet, dass** für die Temperaturregelung als Sollwert eine Temperatur vorgegeben wird, wobei in der Mikrosteuereinheit die aktuell gemessene Temperatur mit der Vorgabe verglichen wird und die Laserleistung geregelt wird, indem die aktuelle, gemessene Temperatur der Vorgabe folgt.

15. Lasermodul nach Anspruch 13, **dadurch gekennzeichnet, dass** über eine digitale Schnittstelle das Lasermodul mit einer der folgende Betriebsarten betrieben wird
(a) Stromvorgabe bei einfacher Stromregelung
(b) Temperaturvorgabe bei Stromregelung mit überlagertere Temperaturregelung
(c) Leistungsvorgabe bei Stromregelung mit überlagerter Leistungsregelung
